# EUROPEAN PATENT SPECIFICATION

(11) **EP 4 579 749 B1**
(45) Date of publication and mention of the grant of the patent: **18.11.2026**
(21) Application number: 24181277.5
(22) Date of filing: 11.06.2024
(51) Int. Cl.: H10D 89/60, H10D 10/01, H10D 62/10, H10D 62/13

(54) **ELECTROSTATIC DEVICE**
ELEKTROSTATISCHE VORRICHTUNG
DISPOSITIF ELECTROSTATIQUE

(30) Priority: 27.12.2023 US 202318397008
(43) Date of publication of application: 02.07.2025
(73) Proprietor: GLOBALFOUNDRIES Singapore Pte. Ltd., Singapore 738406 (SG)
(72) Inventor: ZENG, Jie, 738406 Singapore (SG); HWANG, Kyong Jin, 738406 Singapore (SG)
(74) Representative: Lambacher, Michael

(56) References cited:
- US-A1- 2018 315 641
- US-A1- 2019 189 786
- US-A1- 2020 403 103
- US-A1- 2021 134 787
- US-A1- 2023 085 420

## Description

### BACKGROUND

The present disclosure relates to semiconductor structures and, more particularly, to electrostatic devices and methods of manufacture.

For more efficient power delivery in electric systems such as an electric vehicle, operation voltage is becoming higher and higher. And as integrated circuits continue to shrink in size, they become more sensitive to electrostatic discharge. This high voltage usage and continued scaling of devices require an electrostatic device (ESD) protection device with the capability of sustaining such high voltage with sufficient enough robustness in a small footprint.

Conventionally, a method of stacking low voltage ESD devices have been used to achieve high voltage operation capability. But the stacking method multiplies the ESD device footprint by the stacking number. Also, the use of multiple ESD devices results in an increased turn-on resistance.
US 2023/085420 A1 describes an ESD protection device comprising a first isolation region disposed between a collector region and an emitter region, and a second isolation region disposed between the emitter region and a base region. Salicide block (SAB) layers are arranged over the first isolation region and second isolation region and partially overlap with the emitter region, base region, and collector region. Further, US 2018/315641 A1 describes a bipolar ESD protection device comprising a collector region adjacent to an emitter region and an isolation structure between the emitter region and the collector region. Further US 2019/189786 A1 describes a transistor structure comprising a shallow trench isolation (STI) region and a trench with a SAB structure adjacent to the STI region.

### SUMMARY

In an aspect of the disclosure, a structure comprises: a device comprising a collector region, an emitter region, and a base region; an oxidation structure within the base region, the oxidation structure comprising a local oxidation in a semiconductor substrate in the base region; and a shallow trench isolation structure abutting the oxidation structure and extending between the base region and the emitter region.

Additional features of the structure are set forth in dependent claims 2 to 14.

In an aspect of the disclosure, a method comprises: forming a device comprising a collector region, an emitter region, and a base region; forming an oxidation structure within the base region, the oxidation structure comprising a local oxidation in a semiconductor substrate in the base region; and forming a shallow trench isolation structure abutting the oxidation structure and extending between the base region and the emitter region.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a structure and respective fabrication processes in accordance with aspects of the present disclosure.
FIGS. 2-5 show additional structures and respective fabrication processes in accordance with aspects of the present disclosure.
FIG. 6 shows a process flow representative of fabrication processes for manufacturing the devices of FIGS. 1-5.

### DETAILED DESCRIPTION

The present disclosure relates to semiconductor structures and, more particularly, to electrostatic devices and methods of manufacture. More specifically, the present disclosure relates to high voltage electrostatic device (ESD) protection devices. In embodiments, the high voltage ESD protection devices comprise a high voltage PNP bipolar transistor with a shallow trench isolation structure abutting a raised oxidation structure, i.e., LOCOS structure, inside a base region. Advantageously, the high voltage ESD protection devices exhibit a small footprint which can sustain high voltage operation, in addition to exhibiting a small turn-on resistance and increased breakdown voltage at higher temperatures.

The electrostatic devices of the present disclosure can be manufactured in a number of ways using a number of different tools. In general, though, the methodologies and tools are used to form structures with dimensions in the micrometer and nanometer scale. The methodologies, i.e., technologies, employed to manufacture the electrostatic devices of the present disclosure have been adopted from integrated circuit (IC) technology. For example, the structures are built on wafers and are realized in films of material patterned by photolithographic processes on the top of a wafer. In particular, the fabrication of the electrostatic devices uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

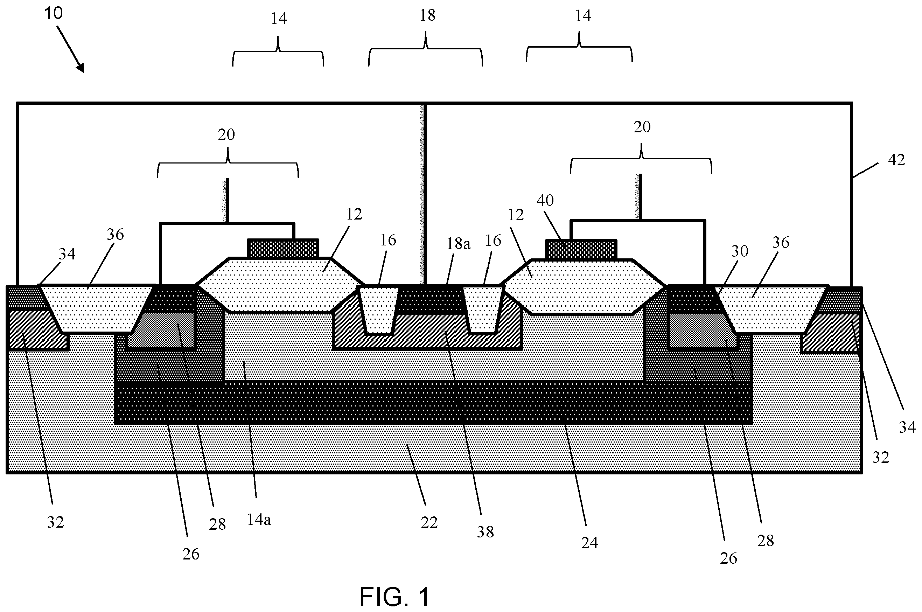

FIG. 1 shows a structure and respective fabrication processes according to aspects of the present disclosure. In embodiments, the structure 10 may be a high voltage PNP device with a local oxidation (LOCOS) 12 in a base region 14 abutting a shallow trench isolation structure 16. The shallow trench isolation structure is between a diffusion region in an emitter region 18 and the base region 14. In embodiments, the PNP device may be a lateral device comprising the emitter region 18, the base region 14 and a collector region 20. It should also be understood by those of skill in the art that the structure 10 may be an NPN device by simply changing the N-regions and P-regions to P-regions and N-regions, respectively.

More specifically, the structure 10 includes a semiconductor substrate 22. In embodiments, the semiconductor substrate 22 may be an epitaxial grown N-type semiconductor substrate. The semiconductor substrate 22 may be composed of any suitable material including, but not limited to, Si, SiGe, SiGeC, SiC, GaAs, InAs, InP, and other III/V or II/VI compound semiconductors. In embodiments, the semiconductor substrate 22 may comprise any suitable crystallographic orientation (e.g., a <100>, <110>, <111>, or <001> crystallographic orientation).

A buried isolation layer 24 may be formed in the semiconductor substrate 22. A drift region 26 may be formed in the semiconductor substrate 22, extending to and contacting the buried isolation layer 24. The buried isolation layer 24 may be a P+ region and the drift region 26 may be a p-type drift region. In embodiments, the combination of the buried isolation layer 24 and the drift region 26 may be used to isolate an N+ drift region 14a, e.g., in the base region 14, the emitter 18 and the collector 20.

FIG. 1 further shows a P-well 28 formed in the p-drift region 26 and a P+ region 30 (e.g., contact) formed in the P-well 28. An N-well 32 with an N+ region (e.g., contact) 34 may also be formed in the semiconductor substrate 22. In embodiments, the N-well 32 with N+ region 34 may be isolated from the P-drift region 26, P-well 28, and P+ region 30 (e.g., contact) by a shallow trench isolation structure 36 formed in the semiconductor substrate 22. The P+ region (e.g., contact) 18a may be formed in an N-well 38 within the drift region 14a. The shallow trench isolation structure 16 directly abuts (e.g., physically contacts) the LOCOS 12. The shallow trench isolation structure 16 may also isolate the P+ region (e.g., contact) 18a. In embodiments, the shallow trench isolation structure 16 is between the P+ diffusion region 18a in an emitter region 18 and the base region 14.

Polysilicon material 40 may be formed on the LOCOS 12. The polysilicon material 40 may be p-type polysilicon material. In embodiments, the polysilicon material is in the collector region 20, electrically connecting to the P+ region 30.

As should be understood by those of skill in the art, the emitter region 18 may comprise the P+ region 18a with the shallow trench isolation structure 16. Additionally, the base region 14 may comprise the N+ drift region 14a and the N-well 38. The collector region 20 may comprise polysilicon material 40, P-drift region 26, P-well 28, P+ region 30. In this way, the emitter region 18, the base region 14 and the collector region 20 form a PNP bipolar junction transistor.

The buried isolation layer 24, P-drift region 26, P-well 28, P+ regions (contacts) 18a, 30, drift region 14a, N-well 32, N+ regions (contacts) 34 and N-well 38 may be formed by conventional ion implantation processes. In a conventional ion implantation process, a concentration of a dopant of certain conductivity type may be introduced into the semiconductor substrate 22.

By way of example, in the conventional ion implantation process, respective patterned implantation masks may be used to define selected areas exposed for the implantations. The implantation mask used to select the exposed area for forming the p-type structures is stripped after implantation, and before the implantation mask used to form the n-type structures of a different conductivity type (or vice versa). The implantation masks may include a layer of a light-sensitive material, such as an organic photoresist, applied by a spin coating process, pre-baked, exposed to light projected through a photomask, baked after exposure, and developed with a chemical developer. Each of the implantation masks has a thickness and stopping power sufficient to block masked areas against receiving a dose of the implanted ions. The P-type features, e.g., buried isolation layer 24, P-drift region 26, P-well 28, and P+ regions 18a, 30 may be doped with p-type dopants, e.g., Boron (B); whereas the drift region 14a, N-well 32, N+ regions (contacts) 34 and N-well 38 may be doped with n-type dopants, e.g., Arsenic (As), Phosphorus (P) and Antimony (Sb), among other suitable examples.

The shallow trench isolation structures 16, 36 can be formed by conventional lithography, etching and deposition methods known to those of skill in the art. For example, a resist formed over the semiconductor substrate 22 is exposed to energy (light) and developed utilizing a conventional resist developer to form a pattern (openings). An etching process with a selective chemistry, e.g., reactive ion etching (RIE), will be used to transfer the pattern to the semiconductor substrate 22 to form one or more trenches in semiconductor substrate 22. Following the resist removal by a conventional oxygen ashing process or other known stripants, insulator material (e.g., SiO₂) can be deposited by any conventional deposition processes, e.g., chemical vapor deposition (CVD) processes. Any residual material on the surface of the semiconductor substrate 22 can be removed by conventional chemical mechanical polishing (CMP) processes.

Wiring structures 42 may be provided to the emitter region 18, the base region 14 and the collector region 20. The wiring structures 42 may be formed by conventional lithography, etching and deposition methods as are known in the art such that no further explanation is required for a complete understanding of the present disclosure. As also should be understood by those of skill in the art, the wiring structures 42 may be formed in interlevel dielectric material, e.g., oxide, nitride or combinations thereof.

Prior to forming the wiring structures 42, a silicide process may be performed to form silicide contacts on the polysilicon material 40, N+ region (e.g., contact) 34 and P+ regions (e.g., contacts) 18a, 30. The reference numerals depicting the polysilicon material 40, N+ region (e.g., contact) 34 and P+ regions 18a, 30 may also be used to identify the silicide contacts.

As should be understood by those of skill in the art, the silicide process begins with deposition of a thin transition metal layer, e.g., nickel, cobalt or titanium, over fully formed and semiconductor devices (e.g., doped or ion implanted regions and polysilicon material 40). After deposition of the material, the structure is heated allowing the transition metal to react with exposed silicon (or other semiconductor material as described herein) in the active regions of the semiconductor device (e.g., doped or ion implanted regions and polysilicon material 40) forming a low-resistance transition metal silicide. Following the reaction, any remaining transition metal is removed by chemical etching, leaving silicide contacts in the active regions of the device.

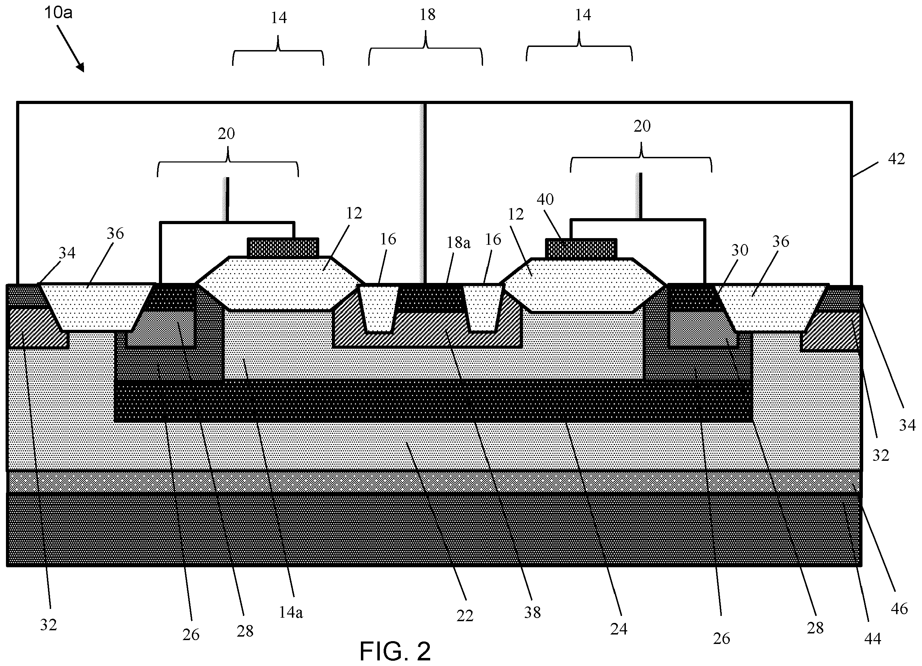

FIG. 2 shows a structure according to additional aspects of the present disclosure. More specifically, the structure 10a of FIG. 2 shows the structure 10 of FIG. 1 on a p-type semiconductor substrate 44. The p-type semiconductor substrate 44 may be isolated from the semiconductor substrate 22 by a buried isolation layer 46. In embodiments, the buried isolation layer 46 may be an N+ buried isolation layer. The buried isolation layer 46 may be formed by either an ion implantation process or an epitaxial growth process with an in-situ doping. As to the former configuration, the buried isolation layer 46 may be formed by an ion implant process into the semiconductor substrate 44. As to the latter configuration, the epitaxial growth process may be used to grow the buried isolation layer 46 and the semiconductor substrate 22 using the same semiconductor material, with a heavier n-type dopant concentration for the buried isolation layer 46. The remaining features of the structure 10a are similar to the structure 10 of FIG. 1.

Examples of various epitaxial growth processes that can be employed in the present disclosure include, e.g., rapid thermal chemical vapor deposition (RTCVD), low-energy plasma deposition (LEPD), ultra-high vacuum chemical vapor deposition (UHVCVD), atmospheric pressure chemical vapor deposition (APCVD) and molecular beam epitaxy (MBE). The epitaxial growth process can be performed utilizing any well-known precursor gas or gas mixture, e.g., hydrogen, nitrogen, helium and argon. A dopant (n-type as noted herein) is typically added to the precursor gas or gas mixture. An annealing process may be performed to drive in the dopant into the semiconductor substrate 22.

The p-type semiconductor substrate 44 may be a bulk handle substrate or semiconductor-on-insulator (SOI) technology. In the SOI technology, from top to bottom, a top semiconductor layer is provided over a buried insulator layer, which is provided over a handle substrate. The handle substrate and top semiconductor layer may be semiconductor material such as, for example, Si, Ge, SiGe, SiC, SiGeC, a III-V compound semiconductor, an II-VI compound semiconductor or any combinations thereof. Typically, the handle substrate and the top semiconductor layer comprises a single crystalline semiconductor material, such as, for example, single crystalline silicon with any suitable crystallographic orientation (e.g., a <100>, <110>, <111>, or <001> crystallographic orientation). The buried insulator layer may include a dielectric material such as silicon dioxide, silicon nitride, silicon oxynitride, boron nitride or a combination thereof. In one embodiment, the buried insulator layer may be a buried oxide layer (BOX).

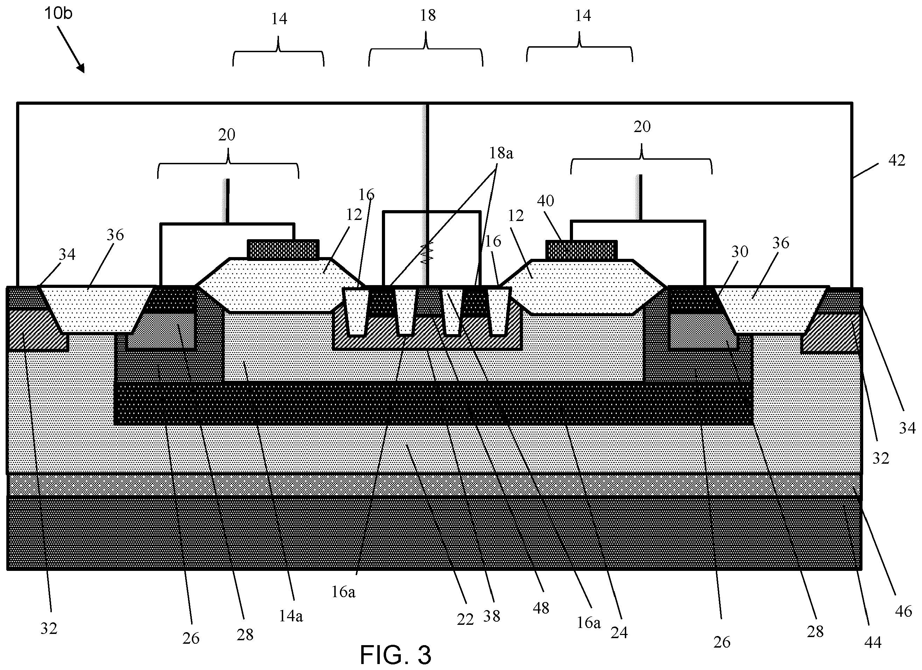

FIG. 3 shows a structure according to additional aspects of the present disclosure. More specifically, the structure 10b of FIG. 3 shows the structure 10a of FIG. 2 with a resistive element in the emitter region 18. More specifically, the resistive element includes an N+ region 48 in the N-well 38, separated from the P+ regions 18a by additional shallow trench isolation structures 16a. The N+ region 48 and the P+ regions 18a in the N-well 38 are electrically connected together by the wiring structures 42. The remaining features of the structure 10b are similar to the structure 10a of FIG. 2 such that no further explanation is required for a complete understanding of the present disclosure.

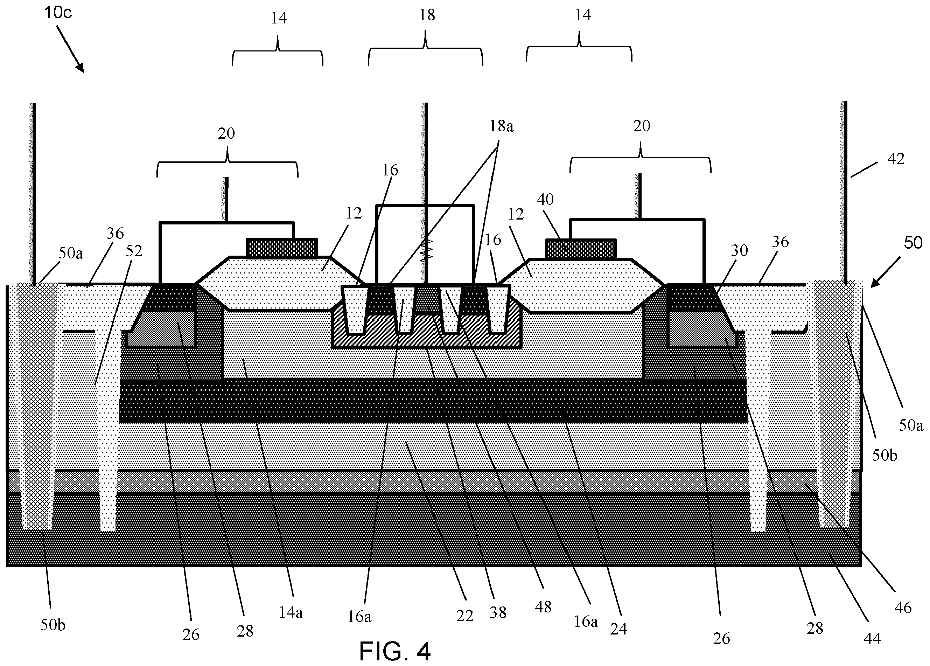

FIG. 4 shows another structure in accordance with further aspects of the present disclosure. The structure 10c of FIG. 4 includes a deep trench structure 50 and a deep trench isolation structure 52. The deep trench structure 50 and the deep trench isolation structure 52 may be formed by conventional lithography, etching and deposition methods as described herein such that no further explanation is required for a complete understanding of the present disclosure. In the structure 10c of FIG. 4, the N-wells 32 and N+ region 34 may be eliminated.

The deep trench structure 50 and the deep trench isolation structure 52 both extend to the underlying p-type semiconductor substrate 44. In addition, the deep trench isolation structure 52 extends through the shallow trench isolation structure 36, adjacent to and, in embodiments, contacting the p-type drift region 26. In this way, the emitter region 18, the collector region 20 and the base region 14 may be isolated using the buried isolation layer 24 and the deep trench isolation structure 52.

In embodiments, the deep trench structure 50 provides contact to a sub-collector region of the device. The deep trench structure 50 includes a sidewall liner comprising insulator material 50a (e.g., SiO₂) and polysilicon material 50b, e.g., p-type polysilicon, extending to the p-type semiconductor substrate 44. The wiring structure 42 may connect to the polysilicon material 50b, e.g., p-type polysilicon. The deep trench isolation structure 52 comprises insulator material, e.g., SiO₂. The remaining features of the structure 10c are similar to the structure 10b of FIG. 3 such that no further explanation is required for a complete understanding of the present disclosure.

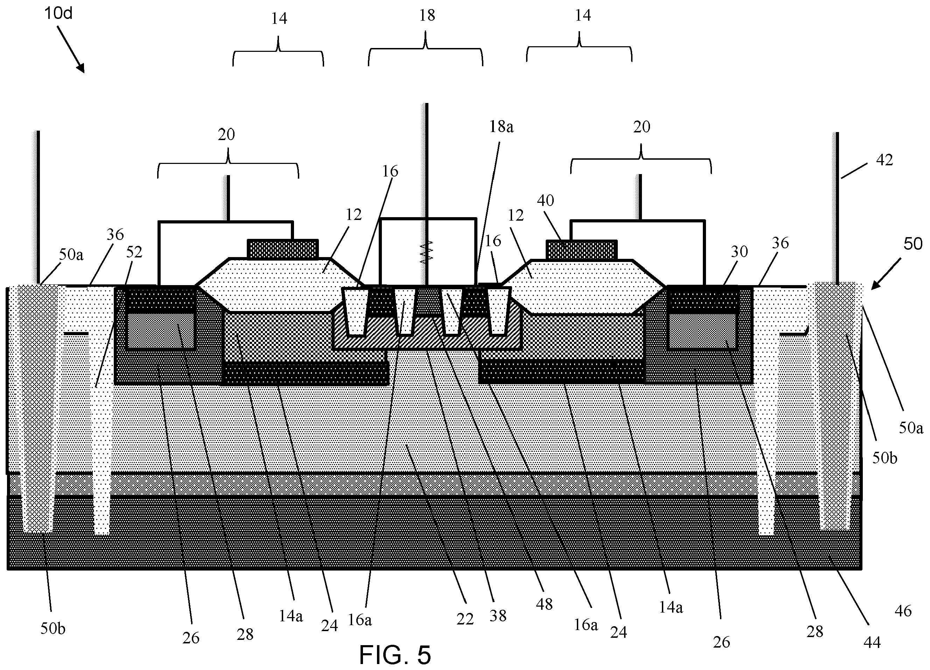

FIG. 5 shows yet another structure in accordance with aspects of the present disclosure. The structure 10d of FIG. 5 includes separate drift regions 14a in the base region 14. The drift regions 14a are isolated using separate buried isolation layers 24, e.g., P+ buried isolation layers. The remaining features of the structure 10d are similar to the structure 10c of FIG. 4 such that no further explanation is required for a complete understanding of the present disclosure.

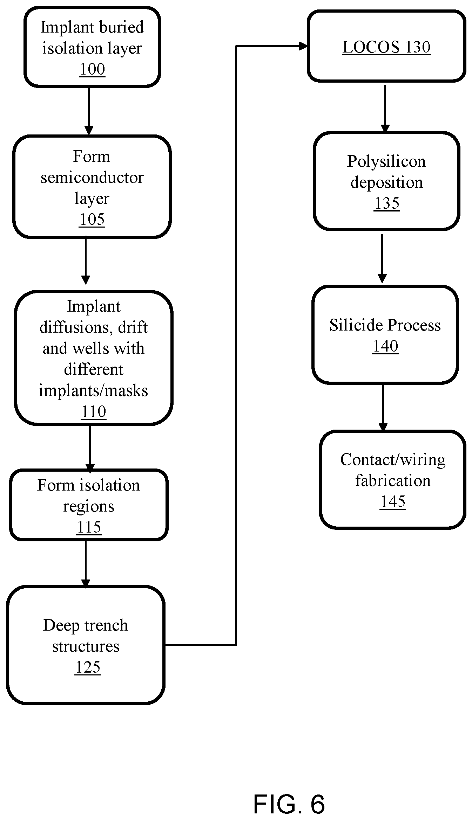

FIG. 6 shows a process flow representative of fabrication processes for manufacturing the devices of FIGS. 1-5. It should be understood that the steps of the process flow may be provided in a different order than provided herein, depending on available tooling and other design and process flow variables as are known in the art.

At step 100, the buried isolation layer 46 may be formed in the semiconductor substrate 44. In embodiments, the buried isolation layer 46 may be formed by an ion implantation process as already noted with respect to FIG. 2.

At step 105, the semiconductor material 22 may be epitaxially grown on the semiconductor substrate 44, over the buried isolation layer 46. In embodiments, the epitaxial growth of the semiconductor material 22 may include an in-situ doping with N-type dopants, e.g., arsenic.

At step 110, the buried isolation layer, diffusion regions, drift regions and implanted regions 18a, 24, 26, 28, 30, 32, 34, 38, 48 may be formed using separate ion implantation processes with different masks as described herein and known in the art such that no further explanation is required for a complete understanding of the present disclosure. In these processes, respective patterned implantation masks may be used to define selected areas exposed for the implantations. The implantation mask used to select the exposed area for forming a single feature is stripped after implantation, and before the implantation mask used to form another feature as is known in the art.

At step 120, the isolation structures 16, 16a, 36 are formed in the semiconductor material 22. In embodiments, the isolation structures 16, 16a, 36 may be shallow trench isolation structures formed by conventional lithography, etching and deposition methods as already described herein.

At step 125, optional deep trench structures 50, 52 may be formed through the semiconductor material 22, extending into the semiconductor material 44. The deep trench structures 50, 52 may be formed by conventional lithography and etching processes, followed by a deposition of insulator material and polysilicon material using a conventional deposition process, e.g., CVD. The deep trench isolation structure 50 may include a step of lining the structure with oxide material 50a followed by anisotropic etching process to remove the insulator from a bottom of the trench. The remaining portion of the deep trench isolation structure may be filled p-doped polysilicon material 50b using a conventional deposition method, e.g., CVD.

At step 130, the LOCOS 12 may be formed abutting to and in direct contact with the shallow trench isolation structures 16. In the LOCOS process, for example, a silicon oxide insulating structure penetrates under the surface of the semiconductor substrate 22 so that an Si-SiO₂ interface occurs at a lower point than the rest of the silicon surface. The LOCOS process includes a thermal oxidation process at selected regions. In this process, the oxygen penetrates in depth of the semiconductor substrate 22, reacts with silicon (or other semiconductor material) and transforms it into, for example, silicon oxide. The LOCOS will be partially extending underneath a surface and within the semiconductor substrate 22, and partially above the surface of the semiconductor substrate 22.

At step 135, polysilicon material 40 may be deposited on the LOCOS 12. The polysilicon material 40 may be epitaxially grown or deposited using conventional deposition methods, e.g., CVD processes, followed by a conventional patterning process.

At step 140, the silicide contacts may be formed using conventional silicide processes as described herein. The silicide may be formed on any of the active regions, e.g., diffusion regions and polysilicon material.

At step 145, the wiring structures (e.g., metal contacts) 42 may be formed using conventional lithography, etching and deposition processes. For example, the wiring structures 42 may be fabricated by forming a via in an interlevel dielectric material, following by deposition of metal material, e.g., tungsten, aluminum, copper, etc., and followed by a chemical mechanical polishing (CMP) process as is known in the art such that no further explanation is required herein for a complete understanding of the present disclosure.

The structures described herein can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multi-chip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprises:
a device comprising a collector region (20), an emitter region (18), and a base region (14);
an oxidation structure (12) within the base region (14), the oxidation structure (12) comprising a local oxidation in a semiconductor substrate in the base region (14); and
a shallow trench isolation structure (16) abutting the oxidation structure (12) and extending between the base region (14) and the emitter region (18).

2. The structure of claim 1, wherein the oxidation structure (12) is a raised isolation structure above a surface of the semiconductor substate (22) and extending below the surface of the semiconductor substrate (22).

3. The structure of claim 1 or claim 2, further comprising polysilicon material (40) on the oxidation structure (12), wherein, optionally, the polysilicon material (40) electrically connects to a diffusion region (30) in the collector region (20).

4. The structure of one of claims 1 to 3, wherein the oxidation structure (12) extends between a diffusion region (30) in the collector region (20) and contacts the shallow trench isolation structure (16).

5. The structure of claim 4, wherein the diffusion region (30) comprises a p-type dopant within a P-well (28) and a P-drift region (26).

6. The structure of claim 5, further comprising a P+ buried isolation layer (24) in the semiconductor substrate (22), wherein the P-drift region (26) and the P+ buried isolation layer (24) isolate an N+ drift region (14a) of the base region (14).

7. The structure of one of claims 1 to 6, wherein the shallow trench isolation structure (16) extends within a first well (38) of a first conductivity type and is adjacent to a diffusion region (18a) of a second conductivity type within the first well, and, optionally, wherein the first conductivity type comprises an n-type dopant and the second conductivity type comprises a p-type dopant.

8. The structure of claim 7, further comprising a resistive element comprising a diffusion region (48) of the first conductivity type between the diffusion region (18a) of the second conductivity type within the first well (38), and, optionally, wherein the diffusion region (48) of the first conductivity type is isolated from the diffusion region (18a) of the second conductivity type by a shallow trench isolation structure (16a).

9. The structure of one of claims 1 to 8, further comprising a first deep trench isolation structure (50) comprising an insulator lining material (50a) and filled polysilicon material (50b) and a second deep trench isolation structure (52) comprising insulator material, the second deep trench isolation structure (52) isolating the emitter region (18), the collector region (20) and the base region (14), and, optionally, wherein the polysilicon material (50b) comprises P-doped polysilicon and extends to the underlying semiconductor substrate beneath an N+ buried layer (46).

10. The structure of claim 1 wherein:
the collector region (20) comprises a P-drift region (26) in the semiconductor substrate (22);
the emitter region (18) comprises a P+ diffusion region (18a) in an N-well (38) and the shallow trench isolation structure (16) is adjacent to the P+ diffusion region (18a);
the base region (14) is within an N-drift region (14a) in the semiconductor substrate (22); and
the local oxidation in the base region (14) extends from the P-drift region (26) and contacts the shallow trench isolation structure (16).

11. The structure of claim 10, wherein the local oxidation (12) in the base region (14) is raised above a top surface of the semiconductor substrate (22) and extends below the top surface of the semiconductor substrate (22).

12. The structure of claim 10 or claim 11, further comprising: a P-doped polysilicon (40) on the local oxidation (12) and electrically connecting to a P+ diffusion region (30) within the P-drift region (26).

13. The structure of one of claims 10 to 12, further comprising a resistive element comprising an N+ diffusion region (48) within the N-well (38) and isolated from the P+ diffusion region (18a) by shallow trench isolation structures (16a) in the N-well (38).

14. The structure of one of claims 10 to 13, further comprising:
a first deep trench isolation structure (52) touching the P-drift region (26) and extending into an underlying substrate below a buried isolation layer (46); and
a second deep trench isolation structure (50) extending into the underlying substrate below the buried isolation layer (46), wherein the second deep trench isolation structure comprises an insulator liner (50a) and a polysilicon material (50b).

15. A method comprises:
forming a device comprising a collector region (20), an emitter region (18), and a base region (14);
forming an oxidation structure (12) within the base region (14), the oxidation structure comprising a local oxidation in a semiconductor substrate in the base region (14); and
forming a shallow trench isolation structure (16) abutting the oxidation structure (12) and extending between the base region (14) and the emitter region (18).

## Patentansprüche

1. Struktur umfassend:
eine Vorrichtung umfassend eine Kollektorregion (20), eine Emitterregion (18) und eine Basisregion (14);
eine Oxidationsstruktur (12) innerhalb der Basisregion (14), wobei die Oxidationsstruktur (12) eine lokale Oxidation in einem Halbleitersubstrat in der Basisregion (14) umfasst; und
eine Flachgrabenisolationsstruktur (16), die an der Oxidationsstruktur (12) anliegt und sich zwischen der Basisregion (14) und der Emitterregion (18) erstreckt.

2. Struktur nach Anspruch 1, wobei die Oxidationsstruktur (12) eine erhöhte Isolationsstruktur über einer Oberfläche des Halbleitersubstrats (22) ist und sich unter die Oberfläche des Halbleitersubstrats (22) erstreckt.

3. Struktur nach Anspruch 1 oder Anspruch 2, ferner umfassend Polysiliziummaterial (40) auf der Oxidationsstruktur (12), wobei optional das Polysiliziummaterial (40) mit einer Diffusionsregion (30) in der Kollektorregion (20) elektrisch verbunden ist.

4. Struktur nach einem der Ansprüche 1 bis 3, wobei sich die Oxidationsstruktur (12) zwischen einer Diffusionsregion (30) in der Kollektorregion (20) erstreckt und die Flachgrabenisolationsstruktur (16) kontaktiert.

5. Struktur nach Anspruch 4, wobei die Diffusionsregion (30) einen p-Typ-Dotierstoff innerhalb einer P-Wanne (28) und einer P-Driftregion (26) umfasst.

6. Struktur nach Anspruch 5, ferner umfassend eine vergrabene P+ Isolationsschicht (24) in dem Halbleitersubstrat (22), wobei die P-Driftregion (26) und die vergrabene P+ Isolationsschicht (24) eine N+ Driftregion (14a) der Basisregion (14) isolieren.

7. Struktur nach einem der Ansprüche 1 bis 6, wobei die Flachgrabenisolationsstruktur (16) sich innerhalb einer ersten Wanne (38) eines ersten Leitfähigkeitstyps erstreckt und benachbart zu einer Diffusionsregion (18a) eines zweiten Leitfähigkeitstyps innerhalb der ersten Wanne ist, und wobei optional der erste Leitfähigkeitstyp einen n-Typ-Dotierstoff umfasst und der zweite Leitfähigkeitstyp einen p-Typ-Dotierstoff umfasst.

8. Struktur nach Anspruch 7, ferner umfassend ein resistives Element umfassend eine Diffusionsregion (48) des ersten Leitfähigkeitstyps zwischen der Diffusionsregion (18a) des zweiten Leitfähigkeitstyps innerhalb der ersten Wanne (38), und wobei optional die Diffusionsregion (48) des ersten Leitfähigkeitstyps von der Diffusionsregion (18a) des zweiten Leitfähigkeitstyps durch eine Flachgrabenisolationsstruktur (16a) isoliert ist.

9. Struktur nach einem der Ansprüche 1 bis 8, ferner umfassend eine erste Tiefgrabenisolationsstruktur (50) umfassend ein Isolatorauskleidungsmaterial (50a) und gefülltes Polysiliziummaterial (50b) und eine zweite Tiefgrabenisolationsstruktur (52) umfassend Isolatormaterial, wobei die zweite Tiefgrabenisolationsstruktur (52) die Emitterregion (18), die Kollektorregion (20) und die Basisregion (14) isoliert, und wobei optional das Polysiliziummaterial (50b) P-dotiertes Polysilizium umfasst and sich zu dem darunterliegenden Halbleitersubstrat unter einer vergrabenen N+ Schicht (46) erstreckt.

10. Struktur nach Anspruch 1, wobei:
die Kollektorregion (20) eine P-Driftregion (26) in dem Halbleitersubstrat (22) umfasst;
die Emitterregion (18) eine P+ Diffusionsregion (18a) in einer N-Wanne (38) umfasst und die Flachgrabenisolationsstruktur (16) benachbart zu der P+ Diffusionsregion (18a) ist;
die Basisregion (14) innerhalb einer N-Driftregion (14a) in dem Halbleitersubstrat (22) ist; und
sich die lokale Oxidation in der Basisregion (14) von der P-Driftregion (26) erstreckt und die Flachgrabenisolationsstruktur (16) kontaktiert.

11. Struktur nach Anspruch 10, wobei die lokale Oxidation (12) in der Basisregion (14) über eine obere Oberfläche des Halbleitersubstrats (22) erhöht ist und sich unter die obere Oberfläche des Halbleitersubstrats (22) erstreckt.

12. Struktur nach Anspruch 10 oder Anspruch 11, ferner umfassend: ein P-dotiertes Polysilizium (40) auf der lokalen Oxidation (12), das mit einer P+ Diffusionsregion (30) innerhalb der P-Driftregion (26) elektrisch verbunden ist.

13. Struktur nach einem der Ansprüche 10 bis 12, ferner umfassend ein resistives Element umfassend eine N+ Diffusionsregion (48) innerhalb der N-Wanne (38), die von der P+ Diffusionsregion (18a) durch Flachgrabenisolationsstrukturen (16a) in der N-Wanne (38) isoliert ist.

14. Struktur nach einem der Ansprüche 10 bis 13, ferner umfassend:
eine erste Tiefgrabenisolationsstruktur (52), welche die P-Driftregion (26) berührt und sich in ein darunterliegendes Substrat unter einer vergrabenen Isolationsschicht (46) erstreckt; und
eine zweite Tiefgrabenisolationsstruktur (50), die sich in das darunterliegende Substrat unter der vergrabenen Isolationsschicht (46) erstreckt, wobei die zweite Tiefgrabenisolationsstruktur einen Isolator-Liner (50a) und ein Polysiliziummaterial (50b) umfasst.

15. Verfahren umfassend:
Bilden einer Vorrichtung umfassend eine Kollektorregion (20), eine Emitterregion (18) und eine Basisregion (14);
Bilden einer Oxidationsstruktur (12) innerhalb der Basisregion (14), wobei die Oxidationsstruktur eine lokale Oxidation in einem Halbleitersubstrat in der Basisregion (14) umfasst; und
Bilden einer Flachgrabenisolationsstruktur (16), die an der Oxidationsstruktur (12) anliegt und sich zwischen der Basisregion (14) und der Emitterregion (18) erstreckt.

## Revendications

1. Structure comprenant :
un dispositif comprenant une région de collecteur (20), une région d'émetteur (18) et une région de base (14) ;
une structure d'oxydation (12) à l'intérieur de la région de base (14), la structure d'oxydation (12) comprenant une oxydation locale dans un substrat semi-conducteur dans la région de base (14) ; et
une structure d'isolation de tranchée peu profonde (16) venant en butée contre la structure d'oxydation (12) et s'étendant entre la région de base (14) et la région d'émetteur (18).

2. Structure selon la revendication 1, dans laquelle la structure d'oxydation (12) est une structure d'isolation surélevée au-dessus d'une surface du substrat semi-conducteur (22) et s'étendant en-dessous de la surface du substrat semi-conducteur (22).

3. Structure selon la revendication 1 ou 2, comprenant en outre un matériau polysilicium (40) sur la structure d'oxydation (12), dans laquelle, optionnellement, le matériau polysilicium (40) se connecte électriquement à une région de diffusion (30) dans la région de collecteur (20).

4. Structure selon l'une des revendications 1 à 3, dans laquelle la structure d'oxydation (12) s'étend entre une région de diffusion (30) dans la région de collecteur (20) et vient en contact avec la structure d'isolation de tranchée peu profonde (16).

5. Structure selon la revendication 4, dans laquelle la région de diffusion (30) comprend un dopant de type p à l'intérieur d'un puits de type P (28) et une région de dérive de type P (26).

6. Structure selon la revendication 5, comprenant en outre une couche d'isolation enterrée de type P+ (24) dans le substrat semi-conducteur (22), dans laquelle la région de dérive de type P (26) et la couche d'isolation enterrée de type P+ (24) isolent une région de dérive de type N+ (14a) de la région de base (14).

7. Structure selon l'une des revendications 1 à 6, dans laquelle la structure d'isolation de tranchée peu profonde (16) s'étend à l'intérieur d'un premier puits (38) d'un premier type de conductivité et est adjacente à une région de diffusion (18a) d'un deuxième type de conductivité à l'intérieur du premier puits, et, optionnellement, dans laquelle le premier type de conductivité comprend un dopant de type n et le deuxième type de conductivité comprend un dopant de type p.

8. Structure selon la revendication 7, comprenant en outre un élément résistif comprenant une région de diffusion (48) du premier type de conductivité entre la région de diffusion (18a) du deuxième type de conductivité à l'intérieur du premier puits (38), et, optionnellement, dans laquelle la région de diffusion (48) du premier type de conductivité est isolée de la région de diffusion (18a) du deuxième type de conductivité par une structure d'isolation de tranchée peu profonde (16a).

9. Structure selon l'une des revendications 1 à 8, comprenant en outre une première structure d'isolation de tranchée profonde (50) comprenant un matériau de revêtement isolant (50a) et un matériau polysilicium (50b) de remplissage et une deuxième structure d'isolation de tranchée profonde (52) comprenant un matériau isolant, la deuxième structure d'isolation de tranchée profonde (52) isolant la région d'émetteur (18), la région de collecteur (20) et la région de base (14), et, optionnellement, dans laquelle le matériau polysilicium (50b) comprend du polysilicium dopé de type P et s'étend jusqu'à un substrat semi-conducteur sous-jacent sous une couche enterrée de type N+ (46).

10. Structure selon la revendication 1, dans laquelle :
la région de collecteur (20) comprend une région de dérive de type P (26) dans un substrat semi-conducteur (22) ;
la région d'émetteur (18) comprend une région de diffusion de type P+ (18a) dans un puits de type N (38) et la structure d'isolation de tranchée peu profonde (16) est adjacente à la région de diffusion de type P+ (18a) ;
la région de base (14) se trouve à l'intérieur d'une région de dérive de type N (14a) dans le substrat semi-conducteur (22) ; et
l'oxydation locale dans la région de base (14), s'étend à partir de la région de dérive de type P (26) et vient en contact avec la structure d'isolation de tranchée peu profonde (16).

11. Structure selon la revendication 10, dans laquelle l'oxydation locale (12) dans la région de base (14) est surélevée au-dessus d'une surface supérieure du substrat semi-conducteur (22) et s'étend en-dessous de la surface supérieure du substrat semi-conducteur (22).

12. Structure selon la revendication 10 ou 11, comprenant en outre : un polysilicium dopé de type P (40) sur l'oxydation locale (12) et se connectant électriquement à une région de diffusion de type P+ (30) à l'intérieur de la région de dérive de type P (26).

13. Structure selon l'une des revendications 10 à 12, comprenant en outre un élément résistif comprenant une région de diffusion de type N+ (48) à l'intérieur du puits de type N (38) et isolée de la région de diffusion de type P+ (18a) par des structures d'isolation de tranchée peu profonde (16a) dans le puits de type N (38).

14. Structure selon l'une des revendications 10 à 13, comprenant en outre :
une première structure d'isolation de tranchée profonde (52) touchant la région de dérive de type P (26) et s'étendant dans un substrat sous-jacent en-dessous d'une couche d'isolation enterrée (46) ; et
une deuxième structure d'isolation de tranchée profonde (50) s'étendant dans le substrat sous-jacent en-dessous de la couche d'isolation enterrée (46), dans laquelle la deuxième structure d'isolation de tranchée profonde comprend un revêtement isolant (50a) et un matériau polysilicium (50b).

15. Procédé comprenant :
la formation d'un dispositif comprenant une région de collecteur (20), une région d'émetteur (18) et une région de base (14) ;
la formation d'une structure d'oxydation (12) à l'intérieur de la région de base (14), la structure d'oxydation comprenant une oxydation locale dans un substrat semi-conducteur dans la région de base (14) ; et
la formation d'une structure d'isolation de tranchée peu profonde (16) venant en butée contre la structure d'oxydation (12) et s'étendant entre la région de base (14) et la région d'émetteur (18).
